# DEMANDE DE BREVET EUROPEEN

(11) **EP 2 306 542 A1**
(43) Date de publication de la demande: **06.04.2011**
(21) Numéro de dépôt: 10354042.3
(22) Date de dépôt: 03.09.2010
(51) Int. Cl.: H01L 51/00, B81C 1/00

(54) **Procédé de réalisation de motifs localisés**

(30) Priorité: 30.09.2009 FR 0904666
(71) Demandeur: Commissariat à l'Énergie Atomique et aux Énergies Alternatives, 75015 Paris (FR)
(72) Inventeur: Benwadih, Mohamed, 94500 Champigny-sur-Marne (FR)
(74) Mandataire: de Jong, Jean Jacques

(57) **Abrégé**

Un procédé de réalisation d'au moins un motif sur une face supérieure d'un support 1 en un matériau présentant une première conductivité thermique, comprend la disposition d'un masque 7, en un matériau présentant une deuxième conductivité thermique et comportant au moins un évidement 8 ayant une forme correspondant à celle du motif, en contact avec une face inférieure du support 1, le rapport de la première conductivité sur la seconde conductivité étant supérieur ou égal à 2, ou inférieur ou égal à 1/2, pendant la durée du procédé. Le procédé comprend en outre une étape de dépôt sur la face supérieure d'une solution comprenant un matériau destiné à former le motif, et une étape d'évaporation de la solution.

## Description

### Domaine technique de l'invention

L'invention concerne un procédé de réalisation d'au moins un motif sur une face supérieure d'un support.

### État de la technique

Les techniques de structuration de couches couramment employées sont, par exemple, la photolithographie et la gravure ou le dépôt à travers un masque selon la technique du pochoir. Ces techniques de la microélectronique sont coûteuses et mal adaptées au dépôt de couches organiques. Dans ce cas, les techniques d'impression sont préférées car elles sont peu coûteuses, faciles à mettre en place et permettent l'utilisation de supports de grandes tailles.

Les techniques telles que l'impression offset, la flexographie, la sérigraphie (impression par écran) et l'impression jet d'encre sont couramment employées pour la fabrication d'électronique imprimée, de préférence l'impression jet d'encre et la sérigraphie.

L'impression jet d'encre est largement utilisée dans la fabrication de dispositifs organiques, par exemple les transistors à effet de champ organiques ou les diodes électroluminescentes organiques. Cette technique d'impression est employée notamment pour l'étape de dépôt d'un semiconducteur organique dans ces dispositifs. Cependant, cette technique est limitée en terme de résolution. En effet, la dimension minimale obtenue est de l'ordre de 50 µm. D'autres techniques d'impression permettent d'obtenir une résolution inférieure, de l'ordre de 20µm, ce qui reste néanmoins insuffisant dans certains cas d'application.

Afin de structurer des motifs plus fins sur un substrat, il est possible de définir sur la surface du substrat des zones lipophiles et des zones lipophobes, ou bien hydrophiles et hydrophobes. Il s'agit donc de modifier l'affinité de la surface du substrat aux corps gras ou à l'eau. Cette étape précède le dépôt d'une solution contenant le matériau à déposer. La solution, comprenant par exemple un semiconducteur organique dissous, est ensuite déposée et se confine dans une zone lipophile ou hydrophile.

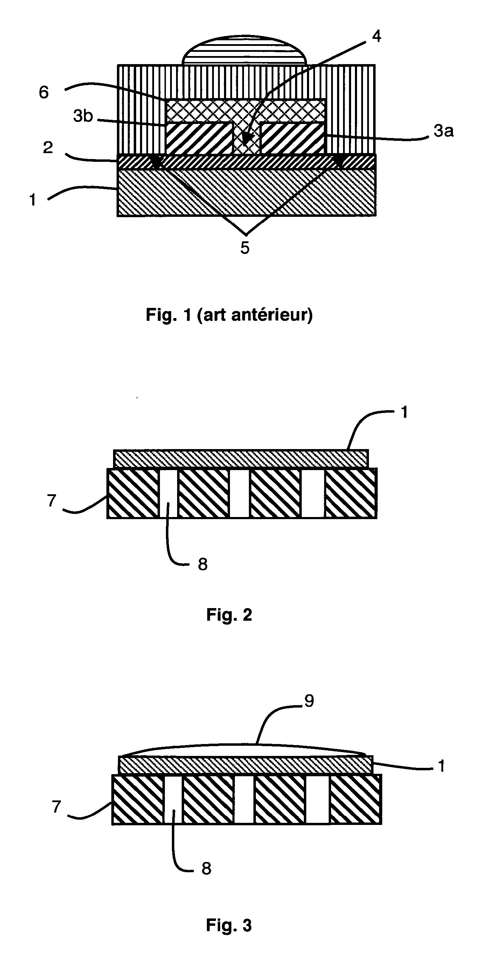

La figure 1 représente un transistor en couches minces obtenu par un procédé de structuration simplifié, décrit dans la demande de brevet US2007/0232035. Le procédé comporte une étape de dépôt sur un substrat 1 d'une couche de polymère 2 ayant une faible énergie de surface. Les électrodes conductrices 3a et 3b (source et drain) du transistor sont ensuite réalisées sur la couche de polymère 2, par exemple par impression jet d'encre ou par dépôt de métal et photolithographie. Elles sont formées d'un matériau ayant une grande énergie de surface. La couche polymère 2 de faible énergie de surface reste libre dans une zone 4 de canal, entre les électrodes 3a et 3b, et dans une zone 5 située autour des électrodes 3a et 3b.

Un matériau semiconducteur en solution est ensuite déposé sur les électrodes 3a et 3b et sur la zone 4 du canal, de préférence par impression jet d'encre. Les électrodes 3a et 3b ayant une énergie de surface supérieure à la couche de polymère 2, la solution est attirée par ces différences en énergie de surface pour recouvrir les faces supérieures des électrodes source et drain, 3a et 3b. La nature de la solution et les conditions de surface, les conditions de mouillage par exemple, sont telles que le semiconducteur en solution est attiré par la surface des électrodes 3a et 3b et repoussé par la zone 5. De plus, malgré la faible énergie de surface de la couche 2 dans la zone 4 de canal, la solution reste confinée dans la zone 4.

Après une étape d'évaporation, la solution se transforme en une couche mince 6 de semiconducteur recouvrant les électrodes 3a et 3b et la zone 4 du canal. Dans la zone 4 du canal, la couche mince de semiconducteur est continue et est en contact avec les parois latérales des électrodes 3a et 3b. Le canal est ainsi formé.

Afin que la solution reste confinée dans la zone 4, l'énergie de surface de la solution peut être augmentée ou le temps d'évaporation peut être diminué.

Le substrat 1 peut être rigide, en verre par exemple, ou flexible, en naphthalate de polyéthylène (PEN) ou téraphthalate de polyéthylène (PET) notamment.

Ce procédé permet donc un confinement auto-aligné d'un îlot semiconducteur formant un canal entre les électrodes source et drain. Cependant, le semiconducteur utilisé par ce procédé n'est pas sous forme cristalline et souvent mal adapté à des procédés de dépôt par jet. De plus, la résolution spatiale des motifs obtenus est limitée par la taille des gouttes et par l'étalement du liquide.

### Objet de l'invention

L'invention vise un procédé de réalisation de motifs haute résolution simple et facile à mettre en oeuvre.

Plus particulièrement, l'invention a pour but un procédé de réalisation de motifs fins entièrement compatible avec un grand nombre de matériaux et les techniques d'impression usuelles, notamment l'impression jet d'encre.

Selon l'invention, ce but est atteint par le fait que le procédé de réalisation d'au moins un motif sur une face supérieure d'un support en un matériau présentant une première conductivité thermique, comprend la disposition d'un masque, en un matériau présentant une deuxième conductivité thermique et comportant au moins un évidement ayant une forme correspondant à celle du motif, en contact avec une face inférieure du support, le rapport de la première conductivité sur la seconde conductivité étant supérieur ou égal à 2, ou inférieur ou égal à 1/2, pendant la durée du procédé. Le procédé comprend en outre une étape de dépôt sur la face supérieure d'une solution comprenant un matériau destiné à former le motif, et une étape d'évaporation de la solution.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente un transistor obtenu par un procédé de structuration selon l'art antérieur
- les figures 2 à 4 représentent des étapes d'un procédé de réalisation de motifs selon l'invention.
- la figure 5 représente une variante de réalisation d'un procédé de réalisation de motifs selon l'invention, et
- la figure 6 représente un transistor obtenu par le procédé selon les figures 2 à 4.

### Description de modes particuliers de réalisation

La figure 2 représente une étape d'un procédé de réalisation d'au moins un motif localisé et structuré. De manière très simple, ce procédé permet la formation de motifs de faibles dimensions, 100nm ou moins par exemple, sur une face supérieure d'un support 1 ou substrat.

Un masque 7 est disposé en contact avec une face inférieure du support 1. Le masque comporte au moins un évidement 8. Sur la figure 2, trois évidements 8 sont représentés. Chaque évidement 8 correspond à un motif que l'on souhaite former sur la face supérieure du support 1. Ainsi, chaque évidement 8 a une forme et des dimensions adaptées au motif à réaliser. L'évidement est, de préférence, traversant, comme représenté sur la figure 2.

La figure 3 représente l'étape suivante du procédé, correspondant au dépôt sur la face supérieure du support 1, d'une solution 9 comprenant un matériau destiné à former les motifs. Le dépôt de cette solution peut-être réalisé par les techniques d'impression usuelles, par impression jet d'encre notamment. La solution recouvre au moins une zone du support 1, sous laquelle sont disposés des évidements 8 du masque 7. De préférence, la solution recouvre toute la surface supérieure du support 1.

Dans un mode de réalisation particulier, la solution 9 comporte au moins un solvant, dans lequel le matériau à déposer est dissous. Le matériau à déposer est, de préférence, un semiconducteur organique, le pentacène par exemple, ou un isolant organique, le polystyrène notamment.

Le matériau à déposer peut également être constitué de nanoparticules dispersées dans un liquide. Dans ce cas, le solvant est remplacé par un dispersant, par exemple l'eau, le Zonyl® de la marque DuPont™ ou un savon. Les nanoparticules peuvent être sous la forme de tubes, de fils ou de sphères, en silicium, silice, métal ou carbone par exemple.

Il a été découvert qu'en plaçant le masque sous le support de la manière décrite ci-dessus, et qu'en éliminant une partie de la solution déposée, la nappe liquide de solution se divise et forme des îlots auto-alignés sur les évidements du masque. Cette séparation en îlots peut être réalisée par une étape d'évaporation de la solution, soit de manière naturelle soit assistée par chauffage.

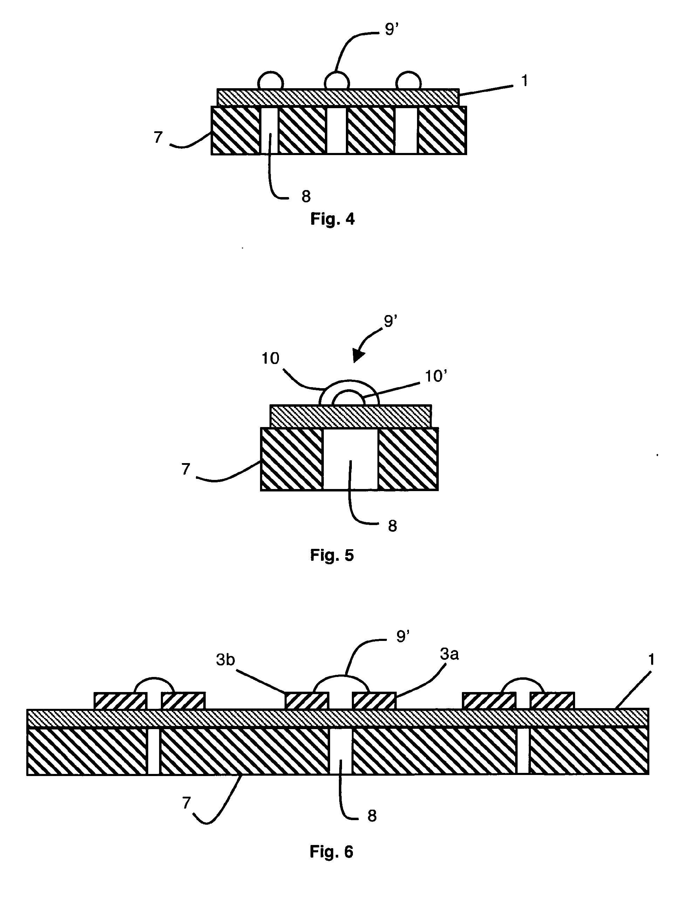

La figure 4 représente la séparation de la solution en îlots 9' pendant l'étape d'évaporation. Chaque îlot 9' se forme au-dessus d'un évidement 8 du masque 7. Ce phénomène de séparation pourrait être dû au rapport des conductivités thermiques entre le support 1 et le masque 7. Le support 1 est en un matériau présentant une première conductivité thermique λ₁. Le masque 7 est en un matériau présentant une deuxième conductivité thermique λ₂. Afin d'obtenir la séparation décrite ci-dessus, le rapport de la première conductivité thermique λ₁ sur la seconde conductivité thermique λ₂ est supérieur ou égal à 2, ou bien inférieur ou égal à 1/2 (λ₁/ λ₂ ≤ 1/2 ou λ₁/ λ₂ ≥ 2) pendant la durée du procédé. Ainsi, soit la conductivité thermique du support λ₁ est au moins deux fois plus grande que la conductivité thermique du masque λ₂, soit inversement λ₂ est au moins deux fois plus grande que λ₁.

De manière générale, un rapport λ₁/λ₂, ou son inverse λ₂/ λ₁, de forte valeur facilite et accélère la formation des îlots 9'. Le rapport de la première conductivité thermique λ₁ sur la conductivité thermique λ₂ est donc préférentiellement supérieur ou égal à 10, ou bien inférieur ou égal à 1 /10. Le support ayant une épaisseur comprise généralement entre 10 µm et 1 mm, la face supérieure du support 1 présenterait des gradients de température pendant l'étape d'évaporation du procédé. Ainsi, la face supérieure du support s'organise en zones dans lesquelles la solution s'évapore plus ou moins vite.

Le support 1 peut être en matière plastique ou en silice. De préférence, le support est souple, en naphthalate de polyéthylène (PEN), en téraphthalate de polyéthylène (PET) ou en polyimide, par exemple. Le masque 7 est, de préférence, en un matériau thermiquement bon conducteur, par exemple en acier inoxydable.

La conductivité thermique dépend en premier lieu de la nature du matériau choisi, mais également de sa température et du champ électrique appliqué. Il est donc possible de jouer sur la température et le champ électrique du masque pour modifier sa conductivité thermique pendant l'étape d'évaporation. Cela est avantageux, par exemple, lorsque les conductivités thermiques standards (conductivités pour une température de 20°C et un champ électrique nul) du masque et du support sont proches. Dans ce cas, le rapport des conductivités λ₁/λ₂ (ou son inverse) est proche de 1 et ne satisfait donc pas la condition pour la formation des îlots. Ainsi, en paramétrant la température du masque et le champ électrique appliqué au masque, il est possible d'atteindre le rapport des conductivités souhaité.

Le procédé comporte donc avantageusement l'application d'un champ électrique sur le masque pendant l'étape d'évaporation. Ce champ électrique est, de préférence, compris entre 1 V/m et 100kV/m.

Le procédé peut également comporter le chauffage ou refroidissement du masque pendant l'étape d'évaporation. Le masque est alors porté à une température comprise entre -100°C et +100°C.

L'étape d'évaporation du procédé permet également la transformation des îlots 9' de solution en motifs dans le matériau choisi.

Dans une variante de réalisation, les évidements 8 sont remplis par un matériau de remplissage, présentant une troisième conductivité thermique λ₃. Le rapport des conductivités thermiques entre le matériau de remplissage et le matériau formant le masque favorise également, sous certaines conditions, la séparation en îlots. Le rapport de la première conductivité λ₁ sur la troisième conductivité λ₃ est supérieur ou égal à 2, ou inférieur ou égal à 1/2, pendant la durée du procédé. Le matériau de remplissage peut être choisi parmi l'air, l'eau, une huile ou tout autre fluide.

Une autre explication du phénomène de séparation pourrait être la modification de l'énergie de surface de la face supérieure du support. En effet, les énergies de surface de la solution et du support, entre autres, influent sur les conditions de mouillabilité de la solution sur le support. La mouillabilité définit, dans la pratique, l'aptitude d'un liquide à se répandre sur un solide. Ainsi, un liquide mouille lorsqu'il adhère et s'étale sur une surface et démouille lorsqu'il n'adhère pas sur la surface.

L'énergie de surface pourrait être texturée suite à l'application du masque 7 sur la face inférieure du support 1, compte tenu de la faible épaisseur du support. Ainsi, les zones de la face supérieure du support situées au-dessus des évidements 8 aurait une énergie de surface différente de celle des zones situées au-dessus du matériau constituant le masque. Le liquide est alors retenu par les zones de la face supérieure du support situées au-dessus des évidements. L'application d'un masque sur la face inférieure du support pourrait donc être une manière simple de texturer l'énergie de surface préalablement au dépôt d'une solution sur la face supérieure du support. Cette technique de structuration peut être améliorée en modifiant certains paramètres de surface. A titre d'exemple, la rugosité conditionne également la mouillabilité du liquide sur le support. De manière générale, une rugosité élevée rend la surface moins mouillante. L'utilisation de plusieurs solvants permet de modifier les paramètres d'évaporation du liquide.

Avantageusement, le volume de la solution est réduit pendant l'étape d'évaporation, par soufflage, raclage ou inclinaison momentanée du support. Cette étape favorise notamment la séparation en îlots de la nappe liquide pendant l'évaporation du solvant ou du dispersant. De plus, cela permet d'évacuer le liquide en surplus, c'est-à-dire le liquide n'ayant pas adhéré au support et ne formant pas les îlots. Dans certains cas, la séparation de la solution en îlots peut être réalisée dans sa totalité par soufflage, raclage ou inclinaison du support.

La figure 5 représente une variante de réalisation du procédé dans laquelle la solution utilisée comporte au moins deux solvants non-miscibles. Les solvants sont notés 10 et 10' sur la figure 5. Le solvant 10 est confiné à la verticale de l'évidement 8 comme décrit en relation avec la figure 4. Le solvant 10', qui contient le matériau à déposer, est confiné par le solvant 10. De cette manière, le solvant 10' définit un motif aux dimensions inférieures à celle de l'évidement 8. La résolution spatiale des motifs est ainsi augmentée.

Ce procédé de réalisation de motifs peut être utilisé dans de nombreuses applications. L'utilisation d'un support en matière plastique est préférée et le procédé convient parfaitement aux dépôts des couches organiques, semiconductrices ou isolantes. Les transistors organiques et les diodes électroluminescentes organiques sont donc des applications privilégiées. La figure 6 représente, à titre d'exemple, la formation des canaux de transistors en couches minces (« Thin Film Transistor », TFT) dans un matériau organique semiconducteur par le procédé selon l'invention.

Les électrodes sources et drain 3a et 3b des transistors sont réalisées sur un support 1 en matière plastique, par exemple en PET de conductivité thermique égale à 0,1 W.m⁻¹.K⁻¹ environ. Le masque 7 en acier inoxydable (conductivité thermique de 100 W.m⁻¹.K⁻¹) est disposé sous le support 1 et comprend des évidements 8, qui peuvent être de tailles différentes. Les évidements 8 sont remplis d'air. Les dimensions de chaque évidement 8 sont adaptées aux dimensions souhaitées pour les différents canaux, par exemple 50 µm. Un semiconducteur organique en solution est déposé sur l'ensemble de la face supérieure du support en matière plastique par impression jet d'encre. Le volume du liquide se réduit par évaporation assisté par un raclage de sa surface, jusqu'à formation des îlots 9' au-dessus des évidements 8. Le masque 7 est maintenu à température ambiante et aucun champ électrique n'est appliqué. Les îlots de solution se transforment ainsi en couches de matériau semiconducteur organique formant les différents canaux des transistors TFT.

## Revendications

1. Procédé de réalisation d'au moins un motif sur une face supérieure d'un support (1) en un matériau présentant une première conductivité thermique (λ₁), comprenant les étapes suivantes :
- disposer un masque (7), en un matériau présentant une deuxième conductivité thermique (λ₂) et comportant au moins un évidement (8) ayant une forme correspondant à celle du motif, en contact avec une face inférieure du support (1), le rapport de la première conductivité sur la seconde conductivité étant supérieur ou égal à 2, ou inférieur ou égal à 1/2, pendant la durée du procédé,
- déposer sur la face supérieure une solution (9) comprenant un matériau destiné à former le motif, et
- évaporer la solution.

2. Procédé selon la revendication 1, **caractérisé en ce que** ledit au moins un motif comprend plusieurs motifs et **en ce que** la solution est déposée de manière à recouvrir l'ensemble de la face supérieure du support (1).

3. Procédé selon l'une des revendications 1 et 2, **caractérisé en ce que** rapport de la première conductivité sur la seconde conductivité est supérieur ou égal à 10, ou inférieur ou égal à 1 /10, pendant la durée du procédé.

4. Procédé selon l'une quelconque des revendications 1 à 3, **caractérisé en ce qu'**il comporte l'application d'un champ électrique sur le masque (7) compris entre 1 V/m et 100 kV/m pendant l'étape d'évaporation.

5. Procédé selon l'une quelconque des revendications 1 à 4, **caractérisé en ce qu'**il comporte le chauffage du masque (7) à une température comprise entre -100 °C et +100 °C pendant l'étape d'évaporation.

6. Procédé selon l'une quelconque des revendications 1 à 5, **caractérisé en ce que** les évidements (8) sont remplis par un matériau de remplissage présentant une troisième conductivité thermique (λ₃) et **en ce que** le rapport de la première conductivité (λ₁) sur la troisième conductivité (λ₃) est supérieur ou égal à 2, ou inférieur ou égal à 1/2, pendant la durée du procédé.

7. Procédé selon la revendication 6, **caractérisé en ce que** le matériau de remplissage est choisi parmi l'air, l'eau ou une huile.

8. Procédé selon l'une quelconque des revendications 1 à 7, **caractérisé en ce que**, pendant l'étape d'évaporation, le volume de la solution (9) est réduit par raclage, soufflage ou inclinaison du support (1).

9. Procédé selon l'une quelconque des revendications 1 à 8, **caractérisé en ce que** le matériau destiné à former les motifs est un semiconducteur organique, un isolant organique ou est constitué de nanoparticules dispersées dans un liquide.

10. Procédé selon la revendication 9, **caractérisé en ce que** les nanoparticules sont sous la forme de tubes, de fils ou de sphères, en silicium, silice, métal ou carbone.

11. Procédé selon l'une quelconque des revendications 1 à 10, **caractérisé en ce que** la solution (9) comporte au moins un solvant (10, 10') ou un dispersant.

12. Procédé selon l'une quelconque des revendications 1 à 11, **caractérisé en ce que** le masque (7) est en acier inoxydable, le support (1) en matière plastique et les évidements (8) emplis d'air.
